# EUROPEAN PATENT SPECIFICATION

(11) **EP 4 618 003 B1**
(45) Date of publication and mention of the grant of the patent: **01.07.2026**
(21) Application number: 23888450.6
(22) Date of filing: 18.10.2023
(51) Int. Cl.: G06T 7/11, G06T 7/00, G01N 23/046, G06N 20/00, G06V 10/70, G06F 30/27

(54) **INFORMATION PROCESSING METHOD, INFORMATION PROCESSING DEVICE, AND INFORMATION PROCESSING PROGRAM FOR GENERATING LEARNING MODEL CAPABLE OF IDENTIFYING VOID IN COMPOSITE MATERIAL**
INFORMATIONSVERARBEITUNGSVERFAHREN, INFORMATIONSVERARBEITUNGSVORRICHTUNG UND INFORMATIONSVERARBEITUNGSPROGRAMM ZUR ERZEUGUNG EINES LERNMODELLS ZUR IDENTIFIZIERUNG VON HOHLRÄUMEN IN VERBUNDMATERIAL
PROCÉDÉ DE TRAITEMENT D'INFORMATIONS, DISPOSITIF DE TRAITEMENT D'INFORMATIONS ET PROGRAMME DE TRAITEMENT D'INFORMATIONS POUR GÉNÉRER UN MODÈLE D'APPRENTISSAGE CAPABLE D'IDENTIFIER DES VIDES DANS UN MATÉRIAU COMPOSITE

(30) Priority: 09.11.2022 JP 2022179745
(43) Date of publication of application: 17.09.2025
(73) Proprietor: IHI Corporation, Tokyo 135-8710 (JP); Katayanagi Institute, Hachioji-shi, Tokyo 192-0982 (JP)
(72) Inventor: KAMAGATA Takanori, Tokyo 135-8710 (JP); SHICHIJO Naohiro, Hachioji-shi, Tokyo 192-0982 (JP); SHIBATA Chihiro, Hachioji-shi, Tokyo 192-0982 (JP)
(74) Representative: MERH-IP Matias Erny Reichl Hoffmann Patentanwälte PartG mbB
(86) International application number: PCT/JP2023/037716
(87) International publication number: WO 2024/101099

(56) References cited:
- WO-A1-2019/059011
- JP-A- 2019 066 993
- JP-A- 2020 129 439
- US-A1- 2021 341 394
- KVIFTE TORD: "Improve Your Deep Learning Models with Image Augmentation", 12 October 2022 (2022-10-12), pages 1 - 7, XP093339338, Retrieved from the Internet <URL:https://web.archive.org/web/20221012152837/https://dev.to/itminds/improve-your-deep-learning-models-with-image-augmentation-4j7f>
- MINGLE XU ET AL: "A Comprehensive Survey of Image Augmentation Techniques for Deep Learning", ARXIV.ORG, CORNELL UNIVERSITY LIBRARY, 201 OLIN LIBRARY CORNELL UNIVERSITY ITHACA, NY 14853, 3 May 2022 (2022-05-03), XP091220309

## Description

### TECHNICAL FIELD

The present disclosure relates to an information processing method, an information processing device, and an information processing program for generating a learning model capable of identifying a void in a composite material.

### BACKGROUND ART

Patent Literature 1 discloses a technique for extracting voids from a three-dimensional image obtained by imaging a fiber-reinforced composite material with an X-ray Computed Tomography device. According to this technique, the three-dimensional image is binarized to generate a binary image, and the binary image is distance-transformed to generate a distance image. Then, a closing process is performed on the binary image using the distance image, and voids are extracted from the difference between the images before and after the closing process.

### CITATION LIST

### PATENT LITERATURE

Patent Literature 1: Japanese Patent Laid-Open Publication No. 2015-068755

### SUMMARY OF THE INVENTION

### TECHNICAL PROBLEM

In order to improve the accuracy of extracting voids in Patent Literature 1, for example, a learning model may be generated by machine learning using a three-dimensional image as teaching data. However, when there are few voids in the three-dimensional image, there is a problem that the accuracy of void identification using the learning model decreases due to a lack of teaching data. This problem is more pronounced when generating a learning model by inspecting a high-quality composite material with fewer voids. Kvifte Tord, "Improve Your Deep Learning Models with Image Augmentation", and Mungle Xu et al, "A Comprehensive Survey of Image Augmentation Techniques for Deep Learning" disclose as well some similar arrangements .

The present disclosure has been made in view of the above-mentioned circumstances. In other words, the present disclosure aims to provide an information processing method, an information processing device, and an information processing program for generating a learning model for accurately identifying voids contained in a composite material including reinforcing material and matrix.

### SOLUTION TO PROBLEM

An information processing method of the present disclosure controls a controller to which teaching data is input, for a first distribution data, the teaching data in which a first label indicating a structural element of a cell is assigned to each cell constituting the first distribution data indicating a physical quantity distribution related to a member including a plurality of structural elements. The controller calculates a ratio of cells to which a specific label indicating that the cells are voids is assigned, to the cells constituting the first distribution data based on the teaching data, determines whether or not the ratio is less than a predetermined threshold, generates modified teaching data from the teaching data by changing the first label assigned to the cell located outside the member to the specific label, if the ratio is less than the predetermined threshold, and performs machine learning based on the modified teaching data to generate a learning model that estimates the first label based on the first distribution data.

The learning model may perform semantic segmentation to estimate the first label based on the first distribution data.

The controller may change the first label assigned to the cell located outside the member and within a predetermined distance from the member to the specific label, if the ratio is less than the predetermined threshold. The predetermined distance may be set based on a kernel size in the semantic segmentation.

The physical quantity distribution may be a distribution representing an absorbance of X-rays at each point inside the member, the distribution being acquired by an X-ray Computed Tomography device.

The controller may identify cells that are located outside the member among the cells that constitute the first distribution data, based on a design data of the member or a three-dimensional measurement data of the member.

The structural element may be at least one of one or more fiber bundles, a matrix, and the void.

The controller may acquire a second distribution data indicating a physical quantity distribution of the member. The controller may estimate a second label indicating whether or not each cell constituting the second distribution data is a void, by calculating an output from the learning model corresponding to an input based on the second distribution data.

The controller may perform a morphology processing on the second distribution data in which the second label has been estimated for each cell, to update the second label for each cell constituting the second distribution data.

An information processing device of the present disclosure comprises an acquiring unit and a controller. The acquiring unit acquires, for a first distribution data, teaching data in which a first label indicating a structural element of a cell is assigned to each cell constituting the first distribution data indicating a physical quantity distribution related to a member including a plurality of structural elements. The controller calculates a ratio of cells to which a specific label indicating that the cells are voids is assigned, to the cells constituting the first distribution data based on the teaching data, determines whether or not the ratio is less than a predetermined threshold, generates modified teaching data from the teaching data by changing the first label assigned to the cell located outside the member to the specific label, if the ratio is less than the predetermined threshold, and performs machine learning based on the modified teaching data to generate a learning model that estimates the first label based on the first distribution data.

An information processing program of the present disclosure processes a first distribution data, the teaching data in which a first label indicating a structural element of a cell is assigned to each cell constituting the first distribution data indicating a physical quantity distribution related to a member including a plurality of structural elements. The computer is caused to execute a step of calculating a ratio of cells to which a specific label indicating that the cells are voids is assigned, to the cells constituting the first distribution data based on the teaching data. The computer is caused to execute a step of determining whether or not the ratio is less than a predetermined threshold. The computer is caused to execute a step of generating modified teaching data from the teaching data by changing the first label assigned to the cell located outside the member to the specific label, if the ratio is less than the predetermined threshold. The computer is caused to execute a step of performing machine learning based on the modified teaching data to generate a learning model that estimates the first label based on the first distribution data.

### ADVANTAGEOUS EFFECTS OF INVENTION

According to the present disclosure, it is possible to generate a learning model for accurately identifying voids contained in a composite material including reinforcing material and matrix.

### BRIEF DESCRIPTION OF DRAWINGS

[Fig. 1] Fig. 1 is a block diagram showing a configuration of an information processing device according to an embodiment of the present disclosure.
[Fig. 2] Fig. 2 is a flowchart showing a processing procedure when generating a learning model of the information processing device according to an embodiment of the present disclosure.
[Fig. 3] Fig. 3 is a flowchart showing a processing procedure when estimating a label of the information processing device according to an embodiment of the present disclosure.
[Fig. 4] Fig. 4 is a diagram showing an example of first distribution data constituting teaching data.
[Fig. 5] Fig. 5 is a diagram showing an arrangement of cells to which a specific label indicating a void is assigned.
[Fig. 6] Fig. 6 is a diagram showing an arrangement of cells to which a specific label indicating a void is assigned in modified teaching data.

### DESCRIPTION OF EMBODIMENTS

Hereinafter, some exemplary embodiments will be described with reference to the drawings. In addition, common parts in the figures are given the same reference numerals, and duplicated explanations will be omitted.

### [Subject of processing by the information processing device]

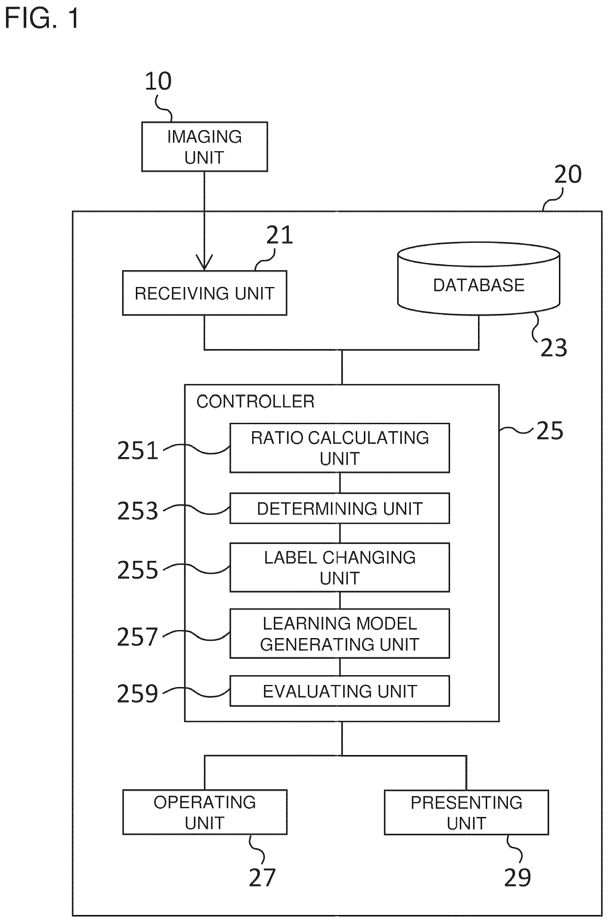

As shown in Fig. 1, the information processing device 20 is connected to the imaging unit 10. Here, the imaging unit 10 irradiates the member to be measured with electromagnetic waves (e.g., X-rays) and detects the electromagnetic waves that are transmitted through the member to obtain the physical quantity distribution inside the member.

For example, the imaging unit 10 is an X-ray Computed Tomography device. In this case, the physical quantity distribution inside the member is acquired by imaging with the imaging unit 10. The "physical quantity distribution" inside the member represents the luminance at each point inside the member. The luminance at each point inside the member is associated with a "physical quantity" at each point, such as the absorbance of X-rays at each point or the degree of attenuation of X-rays. The luminance at each point inside the member itself may be treated as a "physical quantity. "

The imaging unit 10 may acquire the luminance at each point on a predetermined cross section of the member, and generate a two-dimensional image corresponding to the cross section. Here, the predetermined cross section may be arbitrarily set. For example, the coordinate axes of the stationary system of the member may be the X-axis, the Y-axis, and the Z-axis, and the predetermined cross section may be set as a plane parallel to any of the XY plane, the YZ plane, and the XZ plane. Furthermore, the imaging unit 10 may set a plurality of cross sections parallel to each other, group two-dimensional images generated for each cross section, and generate the physical quantity distribution in a three-dimensional space.

The member (composite material) from which the physical quantity distribution is acquired by the imaging unit 10 includes a plurality of structural elements. For example, the structural elements are at least one of a reinforcing material, a matrix, and a void. The member may be obtained by impregnating a molded reinforcing material with a matrix (base material) to compound the reinforcing material and the matrix. The reinforcing material is, for example, graphite, boron nitride, or ceramics such as silicon carbide. The reinforcing material may be a resin such as Kevlar (registered trademark), or an appropriate metal or alloy. The reinforcing material may be made of a plurality of fiber bundles.

The matrix is, for example, a thermosetting resin, a thermoplastic resin, or a ceramic such as silicon carbide. A member whose matrix is made of ceramic is particularly called a ceramic matrix composite (CMC). A void is a gap-like defect that occurs in a member.

The information processing device 20 acquires a physical quantity distribution inside a member including a plurality of structural elements, using the imaging unit 10. As will be described later, the information processing device 20 has a function of identifying the structural element to which a cell included in the member belongs, based on the physical quantity distribution acquired by the imaging unit 10.

A cell is the smallest unit of data for expressing a solid object on a computer. For example, the cell is a pixel or a voxel. The pixel may be a square or rectangle that is a unit element of an orthogonal grid. The pixel may also be another type of polygon. The voxel may be a cube, which is a unit element of an orthogonal lattice. The voxel may also be another type of polyhedron.

On a computer, the member including multiple structural elements is expressed as a set of cells, and each cell has a scalar value and a vector value. By assigning the above-mentioned physical quantity to each cell, the entire set of cells can express the above-mentioned "physical quantity distribution."

### [Configuration of the information processing device]

Fig. 1 is a block diagram showing the configuration of the information processing device 20. The information processing device 20 comprises a receiving unit 21 (acquiring unit), a database 23 (storage unit), a controller 25, an operating unit 27, and a presenting unit 29. The controller 25 is connected to the receiving unit 21, the database 23, the operating unit 27, and the presenting unit 29 so as to be able to communicate with them.

In addition, the operating unit 27 and the presenting unit 29 may be provided in the information processing device 20 itself, or may be installed outside the information processing device 20 and connected to the information processing device 20.

The receiving unit 21 is connected wirelessly or wired to be able to communicate with the imaging unit 10. The receiving unit 21 receives data indicating a physical quantity distribution (a first distribution data, a second distribution data) inside the member from the imaging unit 10. The receiving unit 21 may receive two-dimensional images generated for each predetermined cross section of the member, or may receive data indicating a physical quantity distribution in a three-dimensional space obtained by grouping two-dimensional images.

Furthermore, the receiving unit 21 may receive data indicating the physical quantity distribution (the first distribution data, the second distribution data) from a storage medium or the like. **In** this case, the data indicating the physical quantity distribution stored in the storage medium or the like may be measured using the imaging unit 10 that is not connected to the information processing device 20.

The receiving unit 21 may receive design data of the member or three-dimensional measurement data of the member. The design data of the member is, for example, data generated by CAD (Computer-aided design) when designing the member. The three-dimensional measurement data of the member is, for example, data indicating the outer shape of the member obtained by actually measuring the member using a three-dimensional measuring device.

**In** addition, the receiving unit 21 may receive "teaching data." Here, the "teaching data" refers to data in which a first label indicating the structural element of the cell is added to each cell constituting the first distribution data, the first distribution data indicating a physical quantity distribution related to the member including a plurality of structural elements. A method of adding the first label to each cell constituting the first distribution data will be described later.

The database 23 stores data indicating the physical quantity distribution received by the receiving unit 21. That is, the database 23 may store two-dimensional images generated for each predetermined cross section of the member, or may store data indicating the physical quantity distribution in three-dimensional space. In addition, the database 23 may store a timestamp specifying the date and time of imaging by the imaging unit 10, an identification number specifying the member that was the subject of measurement by the imaging unit 10, and the like, together with the received data.

The operating unit 27 is an input device that can be operated by a user, such as a monitor or maintenance person of the evaluation system. For example, the operating unit 27 is a keyboard, a mouse, a trackball, a touch panel, or the like. The operating unit 27 is not limited to the examples given here. The content of the user's operation input via the operating unit 27 is transmitted to the controller 25.

The operating unit 27 may receive an operation from a user for setting the first label (assigning the first label) indicating a structural element of the cell for each cell constituting the first distribution data, the first distribution data indicating the physical quantity distribution inside the member. The user sets the first label indicating the structural element of the cell for each cell constituting the first distribution data via the operating unit 27 while referring to the first distribution data presented by the presenting unit 29 described later. The first distribution data to which the first label indicating the structural element of the cell is assigned for each cell is input to the controller 25 as "teaching data".

The presenting unit 29 displays the information generated by the controller 25. The presenting unit 29 may also present to the user, data indicating the physical quantity distribution (first distribution data, second distribution data) inside the member, and a label that identifies a structural element to which the voxel contained in the member belongs. Alternatively, the presenting unit 29 may present to the user a label that identifies whether or not the voxel is a void. For example, the presenting unit 29 may be a display that displays figures and characters by combining a plurality of display pixels. The presenting unit 29 is not limited to the examples given here.

The information processing device 20 may include an output unit that outputs information generated by the controller 25 to the outside of the information processing device 20. The output unit may output the label that identifies the structural element to which the cell belongs. The output unit may also output the label that identifies whether or not the cell is a void. The output unit may output a learning model.

The controller 25 (control unit) is a general-purpose computer equipped with a CPU (Central Processing Unit), a memory, and an input/output unit. A computer program (information processing program) for functioning as the information processing device 20 is installed in the controller 25. By executing the computer program, the controller 25 functions as a plurality of information processing circuits (251, 253, 255, 257, 259) equipped in the information processing device 20. The computer program may be stored in a storage medium that can be read and written by a computer. Alternatively, the computer program may be capable of being distributed via a telecommunications line.

In the present disclosure, an example is shown in which multiple information processing circuits (251, 253, 255, 257, 259) are realized by software. However, it is also possible to prepare dedicated hardware for executing each information process shown below to configure the information processing circuits (251, 253, 255, 257, 259). In addition, the multiple information processing circuits (251, 253, 255, 257, 259) may be configured by individual hardware. Furthermore, the information processing circuits (251, 253, 255, 257, 259) may also be used as a control unit used for monitoring or controlling the imaging unit 10.

As shown in Fig. 1, the controller 25 includes a ratio calculating unit 251, a determining unit 253, a label changing unit 255, a learning model generating unit 257, and an evaluating unit 259 as multiple information processing circuits (251, 253, 255, 257, 259).

In addition, when the information processing device 20 does not estimate the label using the learning model, the evaluating unit 259 may be omitted. A controller for estimating the label using the learning model may be prepared separately from the controller 25 including the ratio calculating unit 251, the determining unit 253, the label changing unit 255, and the learning model generating unit 257, and the evaluating unit 259 may be provided in the controller.

The ratio calculating unit 251 calculates, based on the teaching data, the ratio of cells to which a specific label indicating that the cells are voids, among the cells constituting the first distribution data.

For example, the ratio calculating unit 251 may take a value obtained by dividing the volume occupied by all the cells assigned with the specific label indicating that they are voids by the volume of all the cells constituting the first distribution data as the ratio. Also, the ratio calculating unit 251 may take a value obtained by dividing the total number of cells assigned with the specific label indicating that they are voids by the total number of cells constituting the first distribution data as the ratio.

The ratio calculating unit 251 may take a value obtained by dividing the volume occupied by all the cells assigned with the specific label indicating that they are voids by the internal volume of the member as the ratio. The ratio calculating unit 251 may take a value obtained by dividing the total number of cells assigned with the specific label indicating that they are voids by the total number of cells located inside the member as the ratio.

The determining unit 253 determines whether or not the ratio calculated by the ratio calculating unit 251 is less than a predetermined threshold value. Note that the predetermined threshold value is set in advance by the user, for example.

The label changing unit 255 generates modified teaching data from the teaching data. More specifically, when the determining unit 253 determines that the ratio is less than the predetermined threshold, the label changing unit 255 changes the first label assigned to the cell located outside the member in the teaching data to the specific label. Thus, the specific label is assigned to the cell located outside the member in the modified teaching data.

When the determining unit 253 determines that the ratio is less than the predetermined threshold, the label changing unit 255 may change the first labels assigned to cells located outside the member and within a predetermined distance from the member in the teaching data to the specific label. The label changing unit 255 may not change the first labels assigned to cells located outside the predetermined distance.

The predetermined distance may be set based on a kernel size in semantic segmentation. "Semantic segmentation" and "kernel size" will be described later.

Alternatively, the label changing unit 255 may specify cells that are located outside the member among the cells that constitute the first distribution data, based on design data of the member or three-dimensional measurement data of the member.

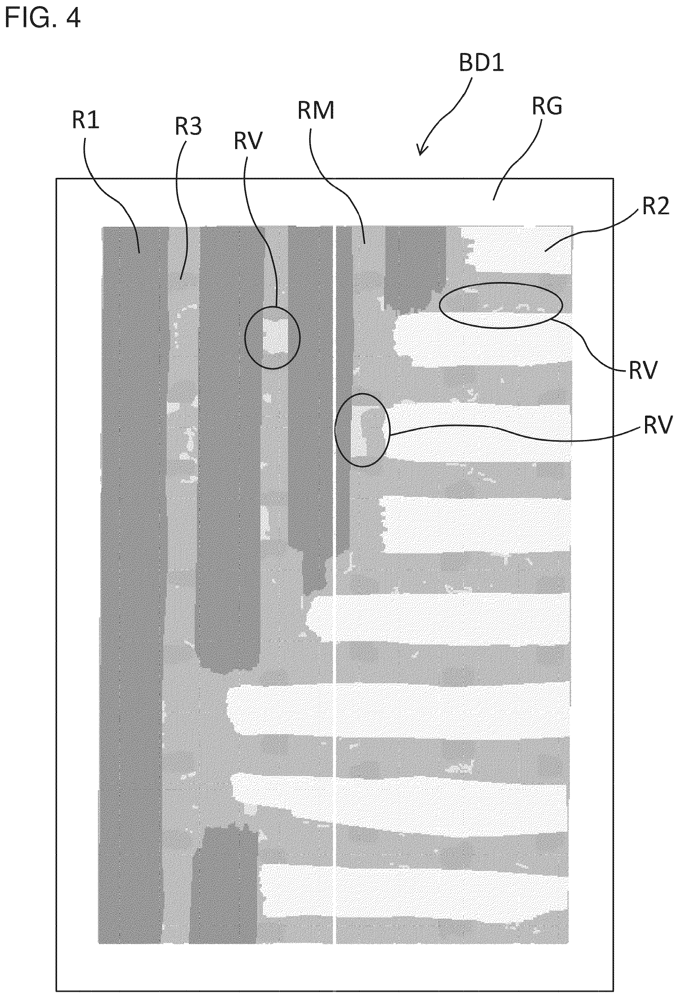

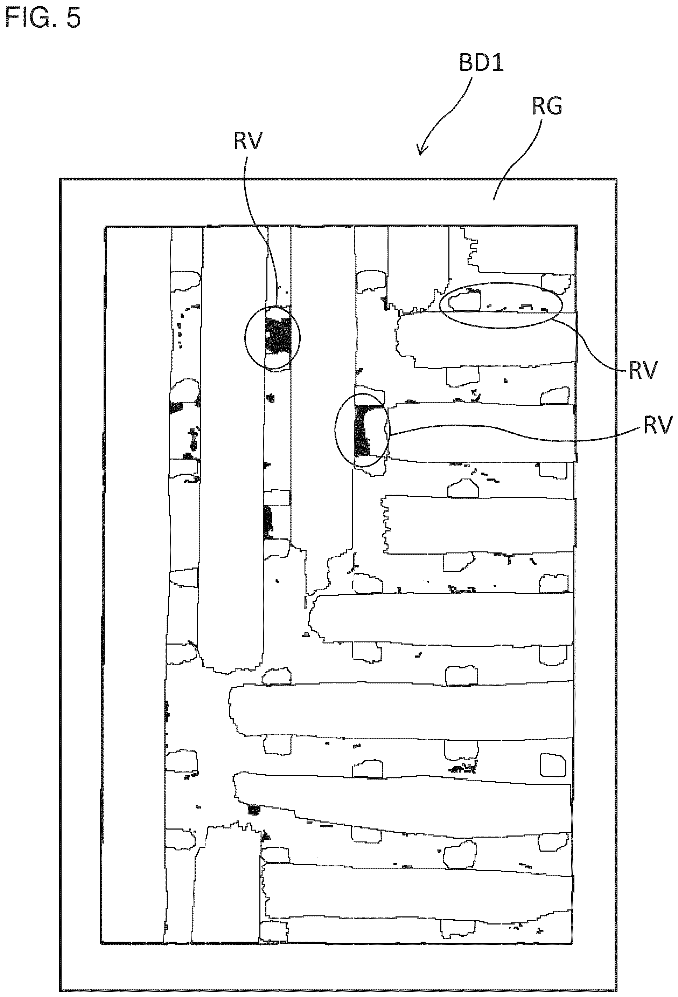

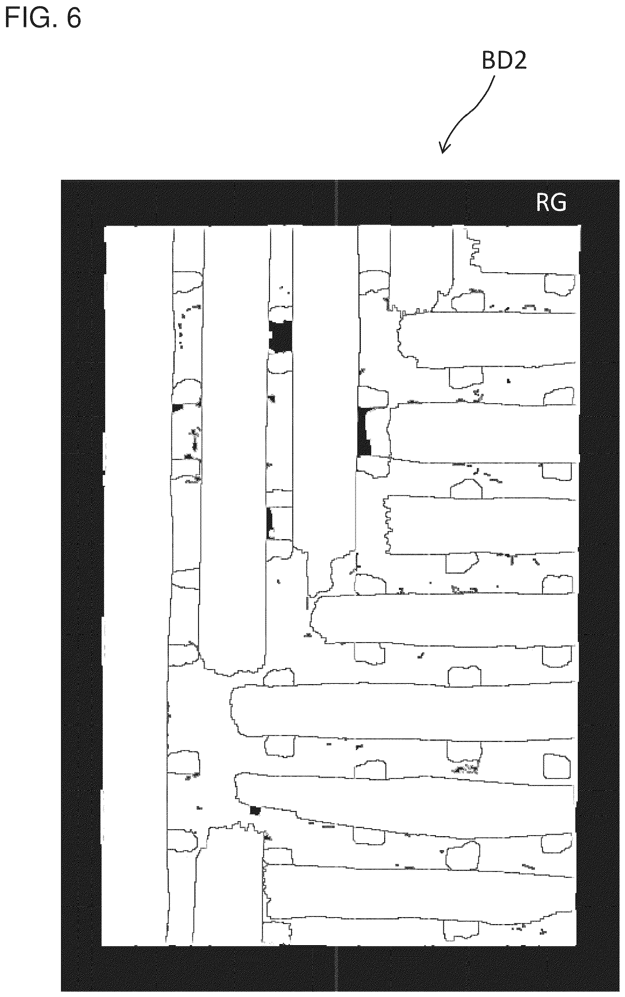

The manner in which the label changing unit 255 changes the first labels assigned to cells located outside the member to specific labels will be described with reference to Figs. 4 to 6. Fig. 4 is a diagram showing an example of first distribution data constituting the teaching data BD1. Fig. 5 is a diagram showing an arrangement of cells assigned with specific labels indicating voids. Fig. 6 is a diagram showing an arrangement of cells assigned with specific labels indicating voids in the modified teaching data BD2. The pixels constituting Figs. 4 to 6 correspond to cells in this embodiment.

In Fig. 4, the different colors of the cells represent the different first labels assigned to the cells. In Fig. 4, the cells made of reinforcing material exist in regions R1, R2, and R3. The region R1 corresponds to the fiber bundles extending in the vertical direction of the paper surface of Fig. 4. The region R2 corresponds to the fiber bundles extending in the horizontal direction of the paper surface of Fig. 4. The region R3 corresponds to the fiber bundles extending in the direction orthogonal to the paper surface of Fig. 4. In addition, cells made of matrix exist in region RM. Cells made of voids exist in region RV. The region of cells located outside the member is shown as region RG.

In Fig. 5, cells consisting of voids are shown in black in correspondence with Fig. 4. In addition, boundaries between regions are shown. Cells with specific labels indicating voids exist in the regions shown in black. According to Fig. 4 and Fig. 5, the volume occupied by cells consisting of voids is smaller than the volume occupied by cells consisting of reinforcing material or matrix. Therefore, when a learning model is generated by performing machine learning based on the teaching data as shown in Fig. 5, the accuracy of void identification using the learning model may decrease due to a lack of teaching data.

Therefore, the label changing unit 255 changes the first label assigned to the cells present in the region RG to a specific label as shown in Fig. 6. As a result, the region RG in Fig. 6 becomes a region in which cells with specific labels indicating voids exist, similar to the region RV.

In this way, by changing the first label assigned to the cells present in the region RG to the specific label, a decrease in the accuracy of void identification using the learning model is suppressed.

The learning model generating unit 257 performs machine learning based on the teaching data or the modified teaching data to generate a learning model that estimates the first label based on the first distribution data. The learning model is represented by, for example, a neural network.

More specifically, the learning model generating unit 257 performs machine learning based on the modified teaching data generated based on teaching data determined by the determining unit 253 to have the ratio less than the predetermined threshold. Also, the learning model generating unit 257 performs machine learning based on teaching data determined by the determining unit 253 to have the ratio equal to or greater than the predetermined threshold.

The learning model generated by the learning model generating unit 257 may perform semantic segmentation to estimate the first label based on the first distribution data. Here, "semantic segmentation" is a deep learning algorithm that associates the first label with the cells that constitute the first distribution data. Examples of learning models that perform semantic segmentation include FCN (Fully Convolutional Network) and U-Net, but the present embodiment is not limited to these.

In addition, in "semantic segmentation," "kernel" refers to a filter used when extracting features from the first distribution data. The filter extracts feature from multiple cells that constitute the first distribution data. The arrangement of cells to be processed by the filter and the number of cells can be set arbitrarily. "Kernel size" is a size that characterizes the size of the arrangement of cells to be processed, and represents, for example, the width of the arrangement of cells to be processed.

As an example of machine learning processing, the learning model generating unit 257 calculates an output obtained when the first distribution data is input to the learning model, and an error or likelihood of the first label for each cell corresponding to the input first distribution data. Then, the learning model generating unit 257 adjusts parameters that define the neural network so that the error is minimized or the likelihood is maximized. As a result of such machine learning processing, the neural network learns features that represent the teaching data or the modified teaching data.

The neural network includes an input layer to which the first distribution data is input, an output layer to which output values are output, and at least one or more hidden layers provided between the input layer and the output layer, and signals are propagated in the order of the input layer, hidden layer, and output layer. Each of the input layer, hidden layer, and output layer is composed of one or more units. The units between the layers are connected to each other, and each unit has an activation function (e.g., a sigmoid function, a normalized linear function, a softmax function, etc.). A weighted sum is calculated based on multiple inputs to the unit, and the value of the activation function with the sum value as a variable becomes the output of the unit.

The learning model generating unit 257 adjusts the weights of the parameters that define the neural network when calculating the weighted sum for each unit, thereby minimizing the error between the output of the neural network and the first label, or maximizing the likelihood of the output. **In** order to minimize the error related to the output of the neural network or maximize the likelihood for multiple teaching data or modified teaching data, a maximum likelihood estimation method or the like can be applied.

**In** order to minimize an error related to the output of the neural network, for example, the learning model generating unit 257 may use a gradient descent method, a stochastic gradient descent method, etc. The learning model generating unit 257 may use an error backpropagation method for gradient calculation in the gradient descent method or the stochastic gradient descent method.

In machine learning using neural networks, generalization performance (the ability to discriminate between unknown data) and overfitting (the phenomenon in which a model adapts to teaching data but does not improve generalization performance) can become problems.

Therefore, in creating the learning model in the learning model generating unit 257, a method such as regularization that restricts the degree of freedom of weights during learning may be used to alleviate overfitting. In addition, a method such as dropout that probabilistically selects units in the neural network and invalidates other units may be used. Furthermore, in order to improve generalization performance, a method such as data regularization, data standardization, and data expansion that eliminate bias in the teaching data or the modified teaching data may be used.

The learning model generated by the learning model generating unit 257 may be stored in the database 23. In addition, the generated learning model may be output to the outside of the information processing device 20 via an output unit (not shown).

The evaluating unit 259 calculates an output from the learning model corresponding to an input based on the second distribution data indicating the physical quantity distribution of the member. That is, the evaluating unit 259 estimates a second label indicating whether or not the structural element of the cell is a void for each cell constituting the second distribution data based on the output from the learning model. The evaluating unit 259 sets the output from the learning model as an estimated value of the second label.

The evaluating unit 259 may acquire a generated learning model from the database 23, instead of acquiring the learning model from the learning model generating unit 257. The evaluating unit 259 may acquire the learning model from outside the information processing device 20.

Alternatively, the evaluating unit 259 may update the second label by performing morphology processing on the second distribution data in which the second label is estimated for each cell (labeled second distribution data).

For example, the evaluating unit 259 performs an "Erosion" process or a "Dilation" process as the morphology processing. The evaluating unit 259 may perform the morphology processing on any one of the cells of the reinforcing material, the cells of the matrix, and the cells of the void included in the second distribution data.

The evaluating unit 259 may repeatedly perform the "Erosion" process and the "Dilation" process a predetermined number of times. The evaluating unit 259 may perform the "Erosion" process and the "Dilation" process in combination. By performing the "Erosion" process, it is possible to remove isolated cells included in the second distribution data in which the second label is estimated. Furthermore, by performing the "Dilation" process, it is possible to connect discontinuous cells and fill in holes in cells.

The evaluating unit 259 may perform an "Opening" process or a "Closing" process. The "Opening" process is a process in which a predetermined number of "Erosion" processes are successively performed, followed by a predetermined number of "Dilation" processes. The "Closing" process is a process in which a predetermined number of "Dilation" processes are successively performed, followed by a predetermined number of "Erosion" processes.

The morphology processing can remove noise contained in the second distribution data from which the second label is estimated. The morphology processing can detect voids that are open to the outside of the member. Even if a continuous structure is actually expressed as a discontinuous structure in the second distribution data, the morphology processing can correct the discontinuous portion to a continuous structure, making it possible to extract fine structures.

### [Processing procedure of information processing device]

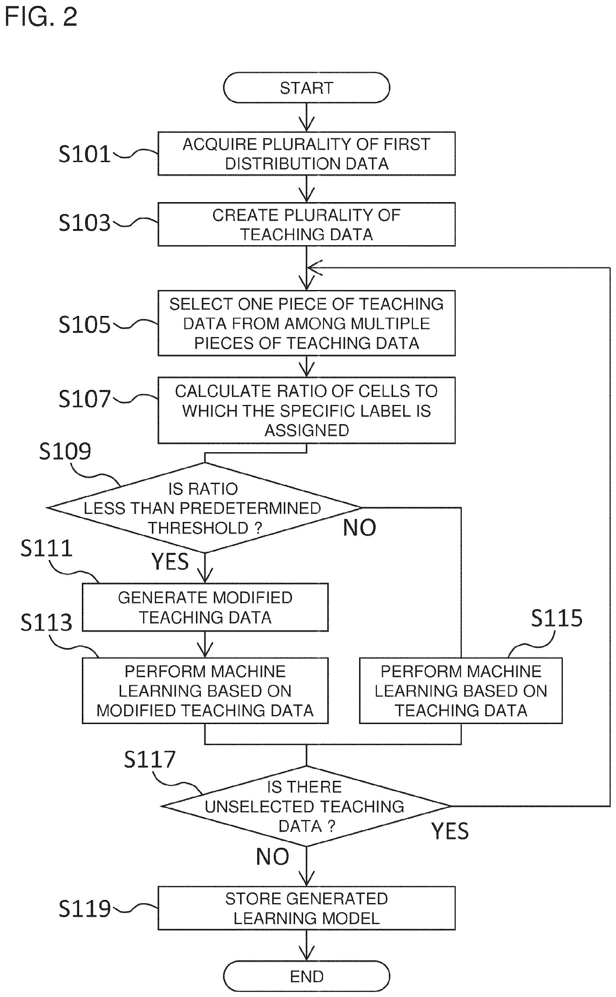

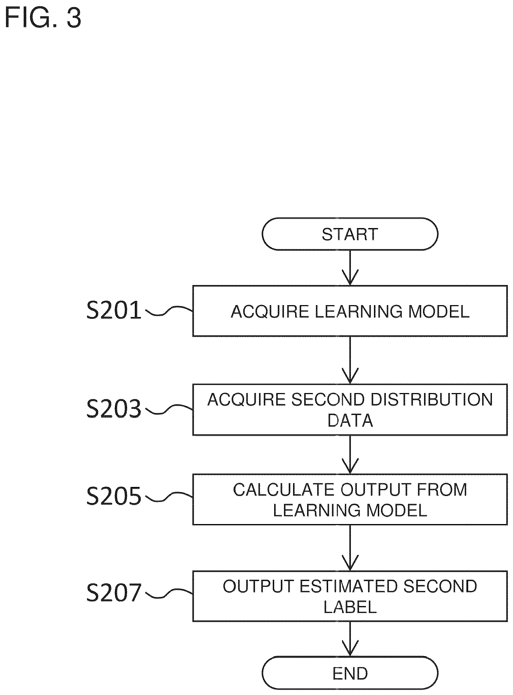

Next, the processing procedure of the information processing device 20 according to the present disclosure will be explained with reference to the flowcharts of Fig. 2 and Fig. 3.

### [Processing procedure for generating the learning model]

Fig. 2 is a flowchart showing a processing procedure when generating a learning model of the information processing device 20 according to an embodiment of the present disclosure. The processing of the flowchart shown in Fig. 2 is started based on, for example, a user instruction.

In step S101, the controller 25 acquires a plurality of first distribution data via the receiving unit 21.

In step S103, the controller 25 sets a first label indicating a structural element of the cell for each cell constituting the first distribution data. Then, the controller 25 creates a plurality of teaching data. When creating the teaching data, the operating unit 27 accepts an operation from the user for setting the first label for each cell.

It should be noted that, instead of steps S101 and S103, the controller 25 may acquire teaching data stored in the database 23.

In step S105, the ratio calculating unit 251 selects one piece of teaching data from among the multiple pieces of teaching data.

In step S107, the ratio calculating unit 251 calculates the ratio of cells to which the specific label is assigned for the selected teaching data.

In step S109, the determining unit 253 determines whether the calculated ratio is less than the predetermined threshold value.

If it is determined that the calculated ratio is less than the predetermined threshold (YES in step S109), in step S111, the label changing unit 255 generates modified teaching data from the teaching data. Then, in step S113, the learning model generating unit 257 performs machine learning based on the modified teaching data.

On the other hand, if it is not determined that the calculated ratio is less than the predetermined threshold value (NO in step S109), in step S115, the learning model generating unit 257 performs machine learning based on the teaching data.

In step S117, it is determined whether or not there is unselected teaching data.

If there is unselected teaching data, the process returns to step S105.

If there is no unselected teaching data, it is understood that processing based on all teaching data has been completed. Therefore, in step S119, the learning model generating unit 257 outputs the generated learning model to the database 23, and the database 23 stores the generated learning model. Alternatively, the learning model generating unit 257 may output the generated learning model to the outside of the information processing device 20.

### [Processing procedure for estimating label]

Fig. 3 is a flowchart showing a processing procedure when estimating a label of the information processing device 20 according to an embodiment of the present disclosure. The processing of the flowchart shown in Fig. 3 is started after the learning model is generated by the flowchart in Fig. 2. Additionally, the processing of the flowchart shown in Fig. 3 is started based on, for example, a user instruction.

In step S201, the evaluating unit 259 acquires the learning model.

In step S203, the controller 25 acquires the second distribution data via the receiving unit 21.

In step S205, the evaluating unit 259 calculates an output from the learning model corresponding to the input based on the second distribution data indicating the physical quantity distribution of the member. The evaluating unit 259 sets the output from the learning model as an estimated value of the second label.

In step S207, the evaluating unit 259 outputs, for each cell constituting the second distribution data, the second label indicating whether or not the structural element of the cell is a void.

### [Effect of Embodiments]

As explained in detail above, an information processing method, an information processing device, and an information processing program according to the present disclosure acquire teaching data. Here, the teaching data is data for a first distribution data, in which a first label indicating a structural element of a cell is assigned to each cell constituting the first distribution data indicating a physical quantity distribution related to a member including a plurality of structural elements. Then the information processing method, the information processing device, and the information processing program calculate a ratio of cells to which a specific label indicating that the cells are voids is assigned, to the cells constituting the first distribution data based on the teaching data, determine whether or not the ratio is less than a predetermined threshold, generate modified teaching data from the teaching data by changing the first label assigned to the cell located outside the member to the specific label, if the ratio is less than the predetermined threshold, and perform machine learning based on the modified teaching data to generate a learning model that estimates the first label based on the first distribution data.

This makes it possible to generate the learning model for accurately identifying voids contained in a composite material including a reinforcing material and a matrix. In particular, even when the learning model is generated for an inspection target of a high-quality composite material with fewer voids, the accuracy of void identification using the learning model is prevented from decreasing. In addition, the learning model can be used to identify voids inside a member, and the void content ratio can be evaluated with high accuracy.

In the information processing method, the information processing device, and the information processing program according to the present disclosure, the learning model may perform semantic segmentation to estimate the first label based on the first distribution data. This makes it possible to output the first label indicating the structural element of the cell for each cell constituting the first distribution data, and to estimate the structural element of the cell. As a result, it is possible to identify voids inside the member using the learning model, and to evaluate the void content ratio with high accuracy.

The information processing method, the information processing device, and the information processing program according to the present disclosure may change the first label assigned to the cell to the specific label, if the ratio is less than the predetermined threshold. The cell to be changed to the specific label may be located outside the member and within a predetermined distance from the member. Then, the predetermined distance may be set based on a kernel size in the semantic segmentation. This prevents a decrease in accuracy of void identification using the learning model, even when the learning model is generated by inspecting a high-quality composite material with fewer voids. Furthermore, an increase in calculation costs when creating the learning model can be suppressed.

In the information processing method, the information processing device, and the information processing program according to the present disclosure, the physical quantity distribution may be a distribution representing an absorbance of X-rays at each point inside the member, the distribution being acquired by an X-ray Computed Tomography device. This allows the physical quantity distribution to be acquired by transmitting the X-rays through the inside of the member. As a result, it is possible to identify voids contained in a composite material including a reinforcing material and a matrix, and to evaluate the void content ratio with high accuracy.

The information processing method, the information processing device, and the information processing program according to the present disclosure may identify cells that are located outside the member among the cells that constitute the first distribution data, based on a design data of the member or a three-dimensional measurement data of the member. This makes it easy to change the first label assigned to the cell located outside the member in the teaching data to the specific label. Therefore, the teaching data regarding voids included in the modified teaching data can be amplified. As a result, the learning model for accurately identifying voids included in a composite material including a reinforcing material and a matrix can be generated.

In the information processing method, the information processing device, and the information processing program according to the present disclosure, the structural element may be at least one of one or more fiber bundles, a matrix, and the void. This allows the structural elements that may be included in the member to be listed, and the learning model to be generated.

The information processing method, the information processing device, and the information processing program according to the present disclosure may acquire a second distribution data indicating a physical quantity distribution of the member. Then, the information processing method, the information processing device, and the information processing program may estimate a second label indicating whether or not each cell constituting the second distribution data is a void, by calculating an output from the learning model corresponding to an input based on the second distribution data. This makes it possible to identify voids inside the member using the learning model and to evaluate the void content ratio with high accuracy.

The information processing method, the information processing device, and the information processing program according to the present disclosure may perform a morphology processing on the second distribution data in which the second label has been estimated for each cell, to update the second label for each cell constituting the second distribution data. This makes it possible to remove noise contained in the second distribution data. Also, it is possible to detect voids that are open to the outside of the member. Furthermore, even if a structure that is actually continuous is expressed as a discontinuous structure in the second distribution data, it is possible to correct the discontinuous portion to a continuous structure by the morphology processing and to extract fine structures.

Respective functions described in the present disclosure may be implemented by one or plural processing circuits. The processing circuits include programmed processors, electrical circuits, etc., as well as devices such as application specific integrated circuits (ASIC) and circuit components arranged to perform the described functions, etc.

According to the present disclosure, it is possible to identify voids contained in a composite material including reinforcing material and matrix, and to evaluate the void content ratio with high accuracy. As a result, it is possible to promote the production of high-quality composite materials. Therefore, it is possible to contribute to, for example, Goal 9 of the Sustainable Development Goals (SDGs) led by the United Nations, "Build resilient infrastructure, promote inclusive and sustainable industrialization and foster innovation."

Although some embodiments have been described, it is possible to modify or transform the embodiments based on the above disclosure contents. All components of the above embodiment, and all the features described in the claims, may be individually extracted and combined as long as they do not contradict each other.

This application claims priority based on Japanese Patent Application No. 2022-179745 filed on November 9, 2022.

### REFERENCE SIGNS LIST

- 10: imaging unit
- 20: information processing device
- 21: receiving unit
- 23: database
- 25: controller
- 27: operating unit
- 29: presenting unit
- 251: ratio calculating unit
- 253: determining unit
- 255: label changing unit
- 257: learning model generating unit
- 259: evaluating unit

## Claims

1. An information processing method for controlling a controller to which teaching data is input, for a first distribution data, the teaching data in which a first label indicating a structural element of a cell is assigned to each cell constituting the first distribution data indicating a physical quantity distribution related to a member including a plurality of structural elements,
by the controller,
calculating a ratio of cells to which a specific label indicating that the cells are voids is assigned, to the cells constituting the first distribution data based on the teaching data,
determining whether or not the ratio is less than a predetermined threshold, generating modified teaching data from the teaching data by changing the first label assigned to the cell located outside the member to the specific label, if the ratio is less than the predetermined threshold, and
performing machine learning based on the modified teaching data to generate a learning model that estimates the first label based on the first distribution data.

2. The information processing method according to claim 1, wherein the learning model performs semantic segmentation to estimate the first label based on the first distribution data.

3. The information processing method according to claim 2, wherein
the controller changes the first label assigned to the cell located outside the member and within a predetermined distance from the member to the specific label, if the ratio is less than the predetermined threshold, and
the predetermined distance is set based on a kernel size in the semantic segmentation.

4. The information processing method according to claim 1, wherein the physical quantity distribution is a distribution representing an absorbance of X-rays at each point inside the member, the distribution being acquired by an X-ray Computed Tomography device.

5. The information processing method according to claim 1, wherein the controller identifies cells that are located outside the member among the cells that constitute the first distribution data, based on a design data of the member or a three-dimensional measurement data of the member.

6. The information processing method according to claim 1, wherein the structural element is at least one of one or more fiber bundles, a matrix, and the void.

7. The information processing method according to any one of claims 1 to 6, wherein the controller
acquires a second distribution data indicating a physical quantity distribution of the member, and
estimates a second label indicating whether or not each cell constituting the second distribution data is a void, by calculating an output from the learning model corresponding to an input based on the second distribution data.

8. The information processing method according to claim 7, wherein the controller performs a morphology processing on the second distribution data in which the second label has been estimated for each cell, to update the second label for each cell constituting the second distribution data.

9. An information processing device comprising an acquiring unit and a controller, wherein
the acquiring unit
acquires, for a first distribution data, teaching data in which a first label indicating a structural element of a cell is assigned to each cell constituting the first distribution data indicating a physical quantity distribution related to a member including a plurality of structural elements,
the controller
calculates a ratio of cells to which a specific label indicating that the cells are voids is assigned, to the cells constituting the first distribution data based on the teaching data,
determines whether or not the ratio is less than a predetermined threshold,
generates modified teaching data from the teaching data by changing the first label assigned to the cell located outside the member to the specific label, if the ratio is less than the predetermined threshold, and
performs machine learning based on the modified teaching data to generate a learning model that estimates the first label based on the first distribution data.

10. A non-transitory computer-readable storage medium storing a program for causing a computer to execute processing for a first distribution data, the teaching data in which a first label indicating a structural element of a cell is assigned to each cell constituting the first distribution data indicating a physical quantity distribution related to a member including a plurality of structural elements,
the processing comprising:
calculating a ratio of cells to which a specific label indicating that the cells are voids is assigned, to the cells constituting the first distribution data based on the teaching data,
determining whether or not the ratio is less than a predetermined threshold,
generating modified teaching data from the teaching data by changing the first label assigned to the cell located outside the member to the specific label, if the ratio is less than the predetermined threshold, and
performing machine learning based on the modified teaching data to generate a learning model that estimates the first label based on the first distribution data.

## Patentansprüche

1. Informationsverarbeitungsverfahren zum Steuern einer Steuerung, in die Trainingsdaten eingegeben werden, für erste Verteilungsdaten, wobei in den Trainingsdaten eine erste Kennzeichnung, die ein Strukturelement einer Zelle angibt, jeder Zelle zugewiesen ist, welche die ersten Verteilungsdaten darstellt, die eine physikalische Größenverteilung in Bezug auf ein Element einschließlich mehrerer Strukturelemente angeben,
durch die Steuerung,
Berechnen eines Verhältnisses von Zellen, denen eine spezifische Kennzeichnung zugewiesen ist, die angibt, dass die Zellen Leerräume sind, zu den Zellen, welche die ersten Verteilungsdaten darstellen, basierend auf den Trainingsdaten,
Bestimmen, ob das Verhältnis kleiner als ein vorbestimmter Schwellenwert ist oder nicht,
Erzeugen modifizierter Trainingsdaten von den Trainingsdaten durch Ändern der ersten Kennzeichnung, die der Zelle zugewiesen ist, die sich außerhalb des Elements befindet, in die spezifische Kennzeichnung, wenn das Verhältnis kleiner ist als der vorbestimmte Schwellenwert, und
Ausführen von maschinellem Lernen basierend auf den modifizierten Trainingsdaten, um ein Lernmodell zu erzeugen, das die erste Kennzeichnung basierend auf den ersten Verteilungsdaten schätzt.

2. Informationsverarbeitungsverfahren nach Anspruch 1, wobei das Lernmodell eine semantische Segmentierung ausführt, um die erste Kennzeichnung basierend auf den ersten Verteilungsdaten zu schätzen.

3. Informationsverarbeitungsverfahren nach Anspruch 2, wobei
die Steuerung die erste Kennzeichnung, die der Zelle zugewiesen ist, die sich außerhalb des Elements und innerhalb eines vorbestimmten Abstands von dem Element befindet, in die spezifische Kennzeichnung ändert, wenn das Verhältnis kleiner ist als der vorbestimmte Schwellenwert, und
der vorbestimmte Abstand basierend auf einer Kernelgröße in der semantischen Segmentierung festgelegt wird.

4. Informationsverarbeitungsverfahren nach Anspruch 1, wobei die physikalische Größenverteilung eine Verteilung ist, die einen Absorptionsgrad von Röntgenstrahlen an jedem Punkt innerhalb des Elements darstellt, und die Verteilung durch eine Röntgencomputertomographievorrichtung erlangt wird.

5. Informationsverarbeitungsverfahren nach Anspruch 1, wobei die Steuerung unter den Zellen, welche die ersten Verteilungsdaten darstellen, Zellen, die sich außerhalb des Elements befinden, basierend auf Designdaten des Elements oder dreidimensionalen Messdaten des Elements identifiziert.

6. Informationsverarbeitungsverfahren nach Anspruch 1, wobei das Strukturelement mindestens eines von einem oder mehreren Faserbündeln, einer Matrix und dem Leerraum ist.

7. Informationsverarbeitungsverfahren nach einem der Ansprüche 1 bis 6, wobei
die Steuerung
zweite Verteilungsdaten erlangt, die eine physikalische Größenverteilung des Elements angeben, und
eine zweite Kennzeichnung schätzt, die angibt, ob jede Zelle, welche die zweiten Verteilungsdaten darstellt, ein Leerraum ist oder nicht, durch Berechnen einer Ausgabe von dem Lernmodell entsprechend einer Eingabe basierend auf den zweiten Verteilungsdaten.

8. Informationsverarbeitungsverfahren nach Anspruch 7, wobei die Steuerung eine Morphologieverarbeitung an den zweiten Verteilungsdaten ausführt, in denen die zweite Kennzeichnung für jede Zelle geschätzt wurde, um die zweite Kennzeichnung für jede Zelle, welche die zweiten Verteilungsdaten darstellt, zu aktualisieren.

9. Informationsverarbeitungsvorrichtung, umfassend eine Erlangungseinheit und eine Steuerung, wobei die Erlangungseinheit
für erste Verteilungsdaten Trainingsdaten erlangt, in denen eine erste Kennzeichnung, die ein Strukturelement einer Zelle angibt, jeder Zelle zugewiesen ist, welche die ersten Verteilungsdaten darstellt, die eine physikalische Größenverteilung in Bezug auf ein Element einschließlich mehrerer Strukturelemente angeben,
die Steuerung
ein Verhältnis von Zellen, denen eine spezifische Kennzeichnung zugewiesen ist, die angibt, dass die Zellen Leerräume sind, zu den Zellen, welche die ersten Verteilungsdaten darstellen, basierend auf den Trainingsdaten berechnet,
bestimmt, ob das Verhältnis kleiner als ein vorbestimmter Schwellenwert ist oder nicht,
modifizierte Trainingsdaten von den Trainingsdaten erzeugt durch Ändern der ersten Kennzeichnung, die der Zelle zugewiesen ist, die sich außerhalb des Elements befindet, in die spezifische Kennzeichnung, wenn das Verhältnis kleiner ist als der vorbestimmte Schwellenwert, und
maschinelles Lernen basierend auf den modifizierten Trainingsdaten ausführt, um ein Lernmodell zu erzeugen, das die erste Kennzeichnung basierend auf den ersten Verteilungsdaten schätzt.

10. Nicht-flüchtiges, computerlesbares Speichermedium, das ein Programm speichert, um einen Computer zu veranlassen, eine Verarbeitung für erste Verteilungsdaten auszuführen, wobei in den Trainingsdaten eine erste Kennzeichnung, die ein Strukturelement einer Zelle angibt, jeder Zelle zugewiesen ist, welche die ersten Verteilungsdaten darstellt, die eine physikalische Größenverteilung in Bezug auf ein Element einschließlich mehrerer Strukturelemente angeben,
wobei die Verarbeitung umfasst:
Berechnen eines Verhältnisses von Zellen, denen eine spezifische Kennzeichnung zugewiesen ist, die angibt, dass die Zellen Leerräume sind, zu den Zellen, welche die ersten Verteilungsdaten darstellen, basierend auf den Trainingsdaten,
Bestimmen, ob das Verhältnis kleiner als ein vorbestimmter Schwellenwert ist oder nicht,
Erzeugen modifizierter Trainingsdaten von den Trainingsdaten durch Ändern der ersten Kennzeichnung, die der Zelle zugewiesen ist, die sich außerhalb des Elements befindet, in die spezifische Kennzeichnung, wenn das Verhältnis kleiner ist als der vorbestimmte Schwellenwert, und
Ausführen von maschinellem Lernen basierend auf den modifizierten Trainingsdaten, um ein Lernmodell zu erzeugen, das die erste Kennzeichnung basierend auf den ersten Verteilungsdaten schätzt.

## Revendications

1. Procédé de traitement d'informations destiné à commander un dispositif de commande dans lequel sont entrées des données d'entraînement, pour des premières données de distribution, les données d'entraînement étant des données dans lesquelles une première étiquette indiquant un élément structurel d'une cellule est attribuée à chaque cellule constituant les premières données de distribution indiquant une distribution de quantités physiques relative à un membre incluant une pluralité d'éléments structurels,
comprenant, par le dispositif de commande,
le calcul d'un rapport entre des cellules auxquelles une étiquette spécifique indiquant que les cellules sont des vides est attribuée, et les cellules constituant les premières données de distribution, sur la base des données d'entraînement,
la détermination si oui ou non le rapport est inférieur à un seuil prédéterminé,
la génération de données d'entraînement modifiées à partir des données d'entraînement par modification de la première étiquette attribuée à la cellule située à l'extérieur du membre en l'étiquette spécifique, si le rapport est inférieur au seuil prédéterminé, et
la mise en œuvre d'un apprentissage machine sur la base des données d'entraînement modifiées pour générer un modèle d'apprentissage estimant la première étiquette sur la base des premières données de distribution.

2. Procédé de traitement d'informations selon la revendication 1, dans lequel le modèle d'apprentissage effectue une segmentation sémantique pour estimer la première étiquette sur la base des premières données de distribution.

3. Procédé de traitement d'informations selon la revendication 2, dans lequel
le dispositif de commande modifie la première étiquette attribuée à la cellule située à l'extérieur du membre et à une distance prédéterminée du membre en l'étiquette spécifique, si le rapport est inférieur au premier seuil prédéterminé, et
la distance prédéterminée est définie sur la base d'une taille de noyau dans la segmentation sémantique.

4. Procédé de traitement d'informations selon la revendication 1, dans lequel la distribution de quantités physiques est une distribution représentant une absorbance de rayons X en chaque point à l'intérieur du membre, la distribution étant acquise par un dispositif de tomographie assistée par ordinateur à rayons X.

5. Procédé de traitement d'informations selon la revendication 1, dans lequel le dispositif de commande identifie des cellules situées à l'extérieur du membre parmi les cellules constituant les premières données de distribution, sur la base de données de conception du membre ou de données de mesure tridimensionnelles du membre.

6. Procédé de traitement d'informations selon la revendication 1, dans lequel l'élément structurel est au moins l'un parmi un ou plusieurs faisceaux de fibres, une matrice et le vide.

7. Procédé de traitement d'informations selon l'une quelconque des revendications 1 à 6, dans lequel le dispositif de commande
acquiert des deuxièmes données de distribution indiquant une distribution de quantités physiques du membre, et
estime une deuxième étiquette indiquant si oui ou non chaque cellule constituant les deuxièmes données de distribution est un vide, par calcul d'une sortie du modèle d'apprentissage correspondant à une entrée sur la base des deuxièmes données de distribution.

8. Procédé de traitement d'informations selon la revendication 7, dans lequel le dispositif de commande effectue un traitement morphologique sur les deuxièmes données de distribution dans lesquelles la deuxième étiquette a été estimée pour chaque cellule, afin de mettre à jour la deuxième étiquette pour chaque cellule constituant les deuxièmes données de distribution.

9. Dispositif de traitement d'informations comprenant une unité d'acquisition et un dispositif de commande, dans lequel :
l'unité d'acquisition
acquiert, pour les premières données de distribution, des données d'entraînement dans lesquelles une première étiquette indiquant un élément structurel d'une cellule est attribuée à chaque cellule constituant les premières données de distribution indiquant une distribution de quantités physiques relative à un membre incluant une pluralité d'éléments structurels,
le dispositif de commande
calcule un rapport entre des cellules auxquelles une étiquette spécifique indiquant que les cellules sont des vides est attribuée, et les cellules constituant les premières données de distribution, sur la base des données d'entraînement,
détermine si oui ou non le rapport est inférieur à un seuil prédéterminé,
génère des données d'entraînement modifiées à partir des données d'entraînement par modification de la première étiquette attribuée à la cellule située à l'extérieur du membre en l'étiquette spécifique, si le rapport est inférieur au seuil prédéterminé, et
met en œuvre un apprentissage machine sur la base des données d'entraînement modifiées pour générer un modèle d'apprentissage estimant la première étiquette sur la base des premières données de distribution.

10. Support de stockage non transitoire lisible par ordinateur, stockant un programme destiné à amener un ordinateur à exécuter un traitement pour des premières données de distribution, les données d'entraînement étant des données dans lesquelles une première étiquette indiquant un élément structurel d'une cellule est attribuée à chaque cellule constituant les premières données de distribution indiquant une distribution de quantités physiques relative à un membre incluant une pluralité d'éléments structurels,
le traitement comprenant :
le calcul d'un rapport entre des cellules auxquelles une étiquette spécifique indiquant que les cellules sont des vides est attribuée, et les cellules constituant les premières données de distribution, sur la base des données d'entraînement,
la détermination si oui ou non le rapport est inférieur à un seuil prédéterminé,
la génération de données d'entraînement modifiées à partir des données d'entraînement par modification de la première étiquette attribuée à la cellule située à l'extérieur du membre en l'étiquette spécifique, si le rapport est inférieur au seuil prédéterminé, et
la mise en œuvre d'un apprentissage machine sur la base des données d'entraînement modifiées pour générer un modèle d'apprentissage estimant la première étiquette sur la base des premières données de distribution.
